# EUROPEAN PATENT APPLICATION

(11) **EP 4 683 472 A1**
(43) Date of publication of application: **21.01.2026**
(21) Application number: 24934353.4
(22) Date of filing: 26.11.2024
(51) Int. Cl.: H10K 30/88, H10K 30/40, H10K 30/50, H10K 71/00, B01D 53/28

(54) **PEROVSKITE PHOTOVOLTAIC MODULE, MANUFACTURING METHOD THEREFOR AND USE THEREOF**

(30) Priority: 24.05.2024 CN 202410655670
(71) Applicant: Xi'an TJ-Solar New Energy Co., Ltd, Xianyang, Shaanxi 712046 (CN)
(72) Inventor: LI, Peizhou, Shaanxi 712046 (CN); ZHAO, Changzheng, Shaanxi 712046 (CN); HAN, Wei, Shaanxi 712046 (CN)
(74) Representative: Novagraaf Technologies
(86) International application number: PCT/CN2024/134642
(87) International publication number: WO 2025/241459

(57) **Abstract**

The present disclosure relates to a perovskite photovoltaic module and a preparation method and a preparation method and application thereof in the technical field of perovskite cells. The perovskite photovoltaic module disposes a planarization layer between adjacent encapsulation layers, enabling two adjacent encapsulation layers (e.g., a first encapsulation layer and a second encapsulation layer) to encapsulate the planarization layer. This arrangement can prevent moisture and oxygen from infiltrating through the interface between the second encapsulation layer and the perovskite solar cell substrate, thereby affecting the packaging effect of the perovskite photovoltaic module. The planarization layer is formed using a curable adhesive and a desiccant, each with a water content of less than 100 ppm, which extends the pathway for moisture and oxygen to enter the interior of the perovskite cell, thereby enhancing the packaging effect. In addition, the package structure of the perovskite photovoltaic assembly is formed using a mature process, allowing the free moisture and oxygen components in the planar layer to be absorbed by the desiccant. This prevents the components from diffusing to other functional layers or devices, reduces the impact of epoxy factors, and enhances the stability of the perovskite solar cell. The preparation process is simple and highly operable, making it suitable for industrial production.

## Description

### Technical Field

The present disclosure relates to the technical field of perovskite cells, and particularly to a perovskite photovoltaic module, a preparation method and application thereof.

### Background

It is well known in the industry that perovskite solar cells have become a popular new type of solar cell due to their high photoelectric conversion efficiency, low cost, and environmentally friendly materials. However, the stability of perovskite solar cells under the illumination remains a significant challenge to be addressed.

The perovskite solar cells known to inventors, due to numerous defects within the perovskite materials, are highly susceptible to absorbing moisture and oxygen from the environment, which accelerate ion migration of perovskite materials under the illumination condition and ultimately leads to phase separation. It can be seen that preventing moisture and oxygen is crucial for enhancing the stability and extending the service lifespan of perovskite photovoltaic modules.

In view of this, the present disclosure has been proposed.

### Summary

An object of the present disclosure is to overcome the shortcomings of the art known to inventors as described above and provide a perovskite photovoltaic module and a preparation method and application there.

To achieve the object above, the present disclosure provides the following technical solutions:
In one aspect, some embodiments of the present disclosure provides a perovskite photovoltaic module, including an encapsulation structure stacked on a perovskite solar cell, wherein the encapsulation structure includes a plurality of encapsulation layers, and a planarization layer is disposed between adjacent encapsulation layers; and the planarization layer includes a curable adhesive and a desiccant, both of which have a water content of less than 100 ppm.

In particular, the desiccant is doped in the curable adhesive, and a weight ratio of the desiccant in the planarization layer is further defined to be 0.01% to 1%. This is because if the desiccant content is too high, the planarization layer is prone to cracking and reduced toughness after film formation. If the desiccant content is too low, there is a problem of poor ability to resist water vapor.

In particular, the desiccant is a metal oxide-based desiccant, and the metal oxide-based desiccant has an average particle size of 10 µm or less, further preferably 0.01 µm to 1 µm. If the average particle size is less than 0.01 µm, the manufacturing cost of dispersing the desiccant particles increases.

In particular, the metal oxide-based desiccant is at least one of a powdered metal oxide selected from barium oxide (BaO) particles, calcium oxide (CaO) particles, strontium oxide (SrO) particles, magnesium oxide (MgO) particles, molecular sieve, and the like.

Further, the metal oxide-based desiccant includes calcium oxide particles and strontium oxide particles, with the mass of the strontium oxide particles accounting for 88% to 95% of the total mass of the strontium oxide particles and the calcium oxide particles. The inventors of the present application have determined that the mass ratio of the strontium oxide particles is 88% or more from the perspective of reducing the water vapor transmission rate of the encapsulation structure, and that the mass ratio of the strontium oxide particles is 95% or less from the perspective of enhancing the planarizationity of the planarization layer.

The calcium oxide particles are particles including calcium oxide (CaO) as a main component, and the strontium oxide particles are particles including strontium oxide (SrO) as a main component. In particular, the calcium oxide (CaO) particles typically include 80% or more of calcium oxide (CaO) on the basis of the mass ratio of the calcium oxide (CaO) particles. The strontium oxide (SrO) particles typically include 80% or more of strontium oxide (SrO) on the basis of the mass of the strontium oxide (SrO) particles.

It is to be noted that the average particle size of the metal oxide-based desiccant in the present application refers to a median value of the volume distribution measured by a dynamic light scattering particle size analyzer. The average particle size is the value measured using a dispersion in which oxide particles are dispersed in a predetermined dispersion medium and subsequently adjusted.

When the planar layer for packaging the perovskite solar cell assembly is formed into a film, the metal oxide-based desiccant is preferably sufficiently small compared to the film thickness, thereby reducing the likelihood of damage to the perovskite solar cell by appropriately adjusting the particle size.

In particular, the curable adhesive may be an epoxy resin, a polyacrylate, or the like, and the curable adhesive can form a planarization layer through photocuring, thermal curing, or photothermal curing. Since the curable adhesive has good fluidity in a liquid state and the curable adhesive has a wide range of selectable options, the planarization layer can be made of resin. In some embodiments, the polymerizable component of the curable adhesive includes a polymerizable compound containing one or more polymerizable unsaturated groups.

In some embodiments, the curable adhesive is a silicone compound having a siloxane chain and a substituent bonded to the polysiloxane chain, the substituent containing a polymerizable unsaturated group.

In some embodiments, the silicone compound may be represented by the following formula (1): 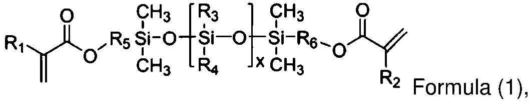 wherein R₁ and R₂ are each independently be hydrogen or methyl; R₃ and R₄ may each independently be alkyl or aryl; R₅ and R₆ may each independently be substituted or unsubstituted C1-C30 alkylene.

In some embodiments, the silicone compound is a compound represented by the structural formula (2) below, with CAS No. 1581235-15-5.

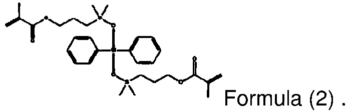

In some embodiments, the content of the silicone compound, on the basis of the mass of the curable adhesive, may be, for example, 5% to 50% of the mass of the curable adhesive.

In some embodiments, the water vapor transmission rate (WVTR) of the planarization layer is less than 10×10⁻⁶g/m²/day. For example, the water vapor transmission rate of the planarization layer may be 2×10⁻⁶g/m²/day, 5×10⁻⁶g/m²/day, 8×10⁻⁶ g/m²/day, or the like.

In particular, the planar layerplanarization layer has a thickness of 0.3 µm to 20 µm. It is to be noted that the thickness of the planarization layer can be adaptively prepared according to actual requirements, with an optional thickness of 0.3 µm, 2 µm, 5 µm, 8 µm, 10 µm, 12 µm, 15 µm, 18 µm, 20 µm, and the like, which are not exhaustively listed here.

In some embodiments, the package layers are each made of dense inorganic materials, and the dense inorganic material may be at least one of silicon oxide (Siₓ₁O_{y1}), silicon nitride (Siₓ₂N_{y2}), silicon oxynitride (SiOₓ₃N_{y3}), zinc oxide (ZnO), antimony trioxide (Sb₂O₂), aluminum oxide (Alₓ₄O_{y4}), indium oxide (In₂O₃), or tin oxide (SnO₂), wherein x1, x2, x3, x4, y1, y2, y3, and y4 are all integers in a range of 1 to 5.

In some embodiments, the encapsulation layer includes a first encapsulation layer and a second encapsulation layer, and the first encapsulation layer and the second encapsulation layer each independently have a thickness of 5 nm to 10 µm. The present application adopts an encapsulation structure including an encapsulation layer with a thickness of 5 nm to 10 µm and a planarization layer with a thickness of 0.3 µm to 20 µm, which offers the advantages of a thin thickness and excellent moisture and oxygen barrier properties. This enhances the toughness of the encapsulation structure of the perovskite solar cell and facilitates the realization of flexible encapsulation for the perovskite solar cell.

It is to be noted that the thicknesses of the first encapsulation layer and the second encapsulation layer each can be adaptively prepared according to actual requirements, with an optional thickness of 5 nm, 50 nm, 100 nm, 500 nm, 1 µm, 3 µm, 5 µm, 7 µm, 8 µm, 9 µm, 10 µm, and the like, which are not exhaustively listed here.

In some embodiments, the first encapsulation layer and the second encapsulation layer by a plasma method or a vacuum method, such as sputtering, chemical vapor deposition (CVD), plasma enhanced chemical vapor deposition (PECVD), evaporation, sublimation, electron cyclotron resonance-plasma enhanced chemical vapor deposition (ECR-PECVD), and a combination thereof.

In another aspect, the present disclosure further provides a preparation method of a perovskite photovoltaic module, and the perovskite photovoltaic module includes two encapsulation layers, with steps mainly including:
Step I . Preparation of perovskite solar cell;
Step II. Preparation of first encapsulation layer;

Above the perovskite solar cell, the material of the first encapsulation layer is coated on the surface of the perovskite solar cell by CVD or PECVD to form the first encapsulation layer.
Step III. Preparation of planarization layer;
   The material of the planarization layer is coated on the surface of the first encapsulation layer by a printing or adhesive coating method, followed by photo-curing, or thermal curing to form the planarization layer.
Step IV. Preparation of second encapsulation layer;

The material of the second encapsulation layer is coated on the surface of the planarization layer by CVD or PECVD to form the second encapsulation layer.

In some embodimentsparticular, the perovskite solar cell includes, along the direction of incident light, a transparent substrate, a first electrode layer, a first transport layer, a perovskite layer, a second transport layer, and a second electrode layer.

It is to be noted that the transparent substrate is not particularly limited in the present disclosure and any conductive substrate known in the art may be used, as long as the object of the present disclosure can be achieved. For example, the transparent substrate may includes a flexible transparent substrate or a rigid transparent substrate, wherein the flexible transparent substrate may be at least one of polyethylene terephthalate (PET), polyethylene naphthalate (PEN), polyimide (PI), colorless polyimide (CPI), polydimethylsiloxane (PDMS), and polyurethane (PU); and the rigid transparent substrate may be a rigid glass substrate.

In some embodiments, the first electrode layer includes a metal oxide electrode layer. In some embodiments,preferably an ITO layer or an FTO layer.

In some embodiments, the second electrode layer includes any one or a combination of at least two of a translucent electrode layer or a transparent electrode layer. In some embodiments, preferably any one or a combination of at least two of a metal electrode layer or a carbon electrode layer, and more preferably, any one or a combination of at least two of a graphene electrode layer, a carbon nanotube electrode layer, a conductive polymer electrode layer, and a metal wire electrode layer. In some embodiments, the metal wire electrode layer is preferably any one of an Au wire electrode layer, an Ag wire electrode layer, a Cu wire electrode layer, and an Al wire electrode layer. Furthermore, the thickness of the metal electrode layer is not particularly limited in the present disclosure as long as the object of the present disclosure can be achieved, and may be, for example, 50 nm to 100 nm. A better effect can be obtained when the thickness of the electrode layer is within this range. Certainly, those skilled in the art can select an appropriate electrode layer thickness according to the requirements, with an optional thickness of 50 nm, 60 nm, 70 nm, 80 nm, 90 nm, 100 nm, and the like, which are not exhaustively listed here. The preparation method of the metal electrode is not particularly limited in the present disclosure, and, for example, a thermal evaporation method may be used.

In some embodiments, the first transport layer is a hole transport layer, and the second transport layer is an electron transport layer. Alternatively, the first transport layer is an electron transport layer, and the second transport layer is a hole transport layer.

In some embodiments, a first interface modification layer is disposed between the first transport layer and a perovskite light absorbing layer. In some embodiments, a second interface modification layer is disposed between the second transport layer and the perovskite light absorbing layer. In some embodiments, the first interface modification layer and the second interface modification layer are each independently selected from an electron blocking layer, a hole blocking layer, and an interface passivation layer.

The hole transport layer is not particularly limited in the present application and may be a material known to those skilled in the art or a combination thereof, for example, any one of a layered structure prepared from nickel oxide, doped nickel oxide, cuprous iodide, cuprous thiocyanate, poly[bis(4-phenyl)(2,4,6-trimethylphenyl)amine] (PTAA), PEDOT: PSS, or Spiro-OMeTAD. In some embodiments, the thickness of the hole transport layer is not particularly limited in the present disclosure as long as the object of the present disclosure can be achieved, and may be, for example, 10 nm to 100 nm. Moreover, the preparation method of the hole transport layer is not particularly limited in the present disclosure, and for example, solution spin coating, solution blade coating, slot-die coating, vapor deposition, or the like can be employed. In some embodiments of the present application, the preparation method of the hole transport layer is slot-die coating.

The material of the electron transport layer is not particularly limited in the present disclosure and may be a material known to those skilled in the art or a combination thereof, and may be selected from, for example, a titanium dioxide (TiO₂) electron transport layer, a tin dioxide (SnO₂) electron transport layer, a fullerene-based (C60) electron transport layer, a zinc oxide (ZnO) electron transport layer, or the like. In some embodiments, the preparation method of the electron transport layer is not particularly limited in the present disclosure, and for example, vacuum evaporation, solution spin coating, solution blade coating, solution spray coating, slot-die coating, hydrothermal growth, or the like can be employed. In some embodiments of the present disclosure, the preparation method of the electron transport layer is slot-die coating.

The perovskite layer is not particularly limited in the present application. In some embodiments, and may be a material known to those skilled in the art or a combination thereof. For example, the perovskite layer includes a perovskite material with an ABO₃-type structure, and the perovskite material is selected from any one of CH₃NH₃PbBr₃, CH₃NH₃Pbl₃, CH₃NH₃Pbl₂Cl, and CH₃NH₃Pb(I₁₋ₓBrₓ)₃, wherein 0 ≤ x ≤ 1. The preparation method of the perovskite layer is not particularly limited in the present disclosure, for example, solution spin coating, solution blade coating, slot-die coating, vapor coating, or the like can be employed. In some embodiments of the present disclosure, the preparation method of the perovskite absorbing layer is slot-die coating.

In addition, some embodiments of the present disclosure further provides application of the perovskite photovoltaic module above in a solar cell.

Compared to the art known to inventors, the technical solution according to the present disclosure includes the following advantageous effects:
(1) In the present disclosure, planarizationity layer is disposed between adjacent encapsulation layers, enabling two adjacent encapsulation layers (e.g., a first encapsulation layer and a second encapsulation layer) to encapsulate the planar layer. This arrangement can prevent moisture and oxygen from permeating through the interface between the second encapsulation layer and the perovskite solar cell substrate, thereby affecting the encapsulation effect of the perovskite photovoltaic module. The planarization layer is formed using a curable adhesive and a desiccant, each with a water content of less than 100 ppm, which extends the pathway for moisture and oxygen to enter the interior of the perovskite cell, thereby enhancing the encapsulation effect.
(2) The encapsulation structure according to the present disclosure is formed using a mature process, allowing the free moisture and oxygen components in the planarization layer to be absorbed by the desiccant. This prevents the components from diffusing to other functional layers or modules, reduces the impact of environmental factors, and enhances the stability of the perovskite solar cell.
(3) The desiccant and the curable adhesive in the present disclosure exhibit good compatibility, with the desiccant being stably and evenly distributed in the curable adhesive over the long term. The planarization layer formed by the two can not only effectively prevent moisture and oxygen from permeating the perovskite photovoltaic module, but also alleviate the stress in the encapsulation layer, thereby enhancing the stability of the perovskite photovoltaic module.
(4) In the present disclosure, the has a thickness of 0.3 µm to 10 µm, and the planarization layer is encapsulated using a nano-scale encapsulation layer structure, significantly reducing the thickness of the perovskite photovoltaic module. This enhances the toughness of the encapsulation structure of the perovskite solar cell, making the encapsulation structure more suitable for flexible encapsulation of the perovskite solar cell.
(5) In the present disclosure, the preparation method is simple and highly operable, making it suitable for industrial production.

### Brief Description of the Drawings

The drawings herein are incorporated into and constitute a part of the description, and together with the description, serve to explain the principles of the present disclosure.

To explain the examples of the present disclosure or the technical solutions in the prior art more clearly, the drawings to be used in the examples or in the description of the prior art are briefly introduced below. It is obvious that those ordinarily skilled in the art would have been able to obtain other drawings according to these drawings without paying any creative labor.
FIG. 1 is a schematic structural diagram of a perovskite photovoltaic module according to Example 1 of the present disclosure; and
FIG. 2 is a graph showing a change in power conversion efficiency over time of a perovskite photovoltaic module prepared in Example 1 and Comparative Example 1 according to the present disclosure in an external air environment.

In the drawings: 10, perovskite solar cell; 21, first encapsulation layer; 22, planarization layer; 23, desiccant; and 24, second encapsulation layer.

### Detailed Description of the Embodiments

Exemplary embodiments are described in detail herein, examples of which are shown in the drawings, and the embodiments described in the following exemplary embodiments do not represent all embodiments consistent with the present disclosure. Rather, the embodiments described are merely examples consistent with some aspects of the present disclosure as detailed in the appended claims.

To enable those skilled in the art to better understand the technical solution of the present disclosure, the present disclosure is described in further detail below with reference to the drawings and embodiments.

### Example 1

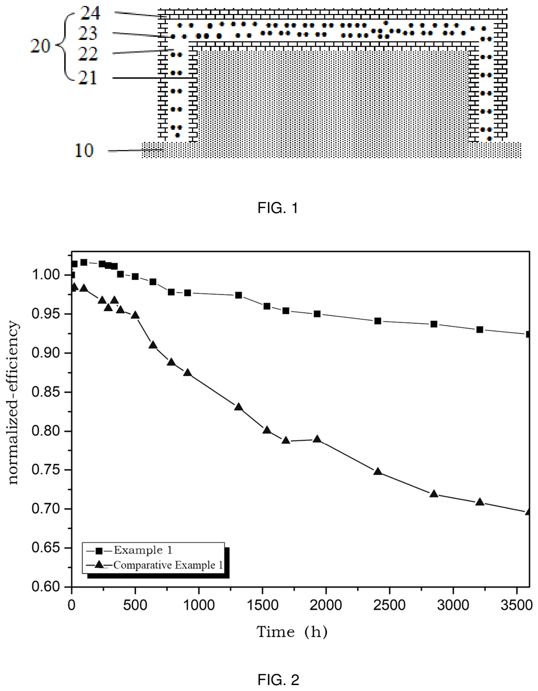

Referring to FIG. 1, the example provides a perovskite photovoltaic module including a perovskite solar cell 10, a first encapsulation layer 21, a second encapsulation layer 24, and a planarization layer 22 disposed between the first encapsulation layer 21 and the second encapsulation layer 24.

The first encapsulation layer 21 is SiOₓ₃N_{y3} (x3 and y3 are each independently an integer in the range of 1 to 5; in the example, x3 = 1, and y3 = 1), and a thickness of 2 µm. The second encapsulation layer is Siₓ₂N_{y2} (x2 and y2 are each independently an integer in the range of 1 to 5; in the example, x2 = 3, and y2 = 4), with a thickness of 2.5 µm.

The planarization layer 22 including a curable adhesive and a desiccant 23, and a weight ratio of the desiccant 23 in the planarization layer 22 is 0.5%.

The curable adhesive is polyacrylate (polyacrylate is a thin-film encapsulation ink purchased from Xi'an SMART MATERIALS Co., Ltd.). The desiccant is a mixture of barium oxide particles and strontium oxide particles, with the mass of the strontium oxide particles accounting for 90% of the total mass of the strontium oxide particles and the calcium oxide particles, the strontium oxide particle has an average particle size of 0.5 µm, and the calcium oxide particle has an average particle size of 0.6 µm. The planarizationity layer has a thickness of 5 µm. It is to be noted that the material of the curable adhesive may also be a mixture of epoxy resin and polyacrylate, with a mass ratio of 1:1.

The preparation method of the perovskite photovoltaic module above includes the following specific steps:
Step I . Preparation of perovskite solar cell 10;
Step II. Preparation of first encapsulation layer 21;

Above the perovskite solar cell 10, the material of the first encapsulation layer 21 was coated on the surface of the perovskite solar cell 10 by a CVD preparation method to form the first layer 21.
At step III, the material of the planarization layer 22 was coated on the surface of the first encapsulation layer 21 by a spin coating method, followed by curing by ultraviolet light to form the planarization layer 22;
Step IV. Preparation of second encapsulation layer 24;

The material of the second encapsulation layer 24 was coated on the surface of the planarization layer 22 by a CVD method to form the second encapsulation layer 24.

The perovskite solar cell 10 includes, along the direction of incident light, a transparent conductive PET substrate, a hole transport layer, a perovskite layer, an electron transport layer, and a metal electrode layer. The preparation steps of the perovskite solar cell 10 are as follows:
Step (1). Preparation of transparent conductive PET substrate: pretreatment of transparent conductive PET substrate: The transparent conductive PET substrate was subjected to ultrasonic treatment in absolute ethanol at a power of 900 W for 20 min. Then, the surface of the transparent conductive PET substrate was evenly sprayed with a nitrogen gun, followed by ultraviolet ozone treatment on the transparent conductive PET substrate for 15 min.
Step (2). Preparation of hole transport layer (HTL): A NiOₓ dispersion with a volume of 160 µL was spin-coated on the transparent conductive PET substrate at a speed of 3000 r/min for 45 s using a spin coater, followed by annealing on a hot plate at 120°C for 15 min.
Step (3). Preparation of perovskite layer: First, 668.3 mg of PbI₂, 228.76 mg of FAl, 7.8 mg of MABr, 14.18 mg of MACI, 18 mg of Csl, and 28 mg of PbBr₂ were mixed and dissolved in 1 mL of a DMF-DMSO mixed solution and stirred for 3 h (wherein the volume ratio of the mixed solution formed by Pbl₂, FAl, MABr, MACI, Csl, and PbBr₂ to the DMF-DMSO solution was 4:1) to prepare a perovskite precursor solution. The prepared perovskite precursor solution was then spin-coated on the NiOₓ functional layer at a spin coating speed of 4000 rpm for 40 s. Additionally, 200 µL of chlorobenzene was added dropwise as an anti-solvent 7 s before the spin coating was completed, followed by annealing at 100°C for 1 h.
Step (4). Preparation of electron transport layer: The substrate above was transferred to a chamber of a vacuum evaporation machine, and the air pressure was pumped down to 4×10⁻³ Pa or less and maintained. The temperature of the C₆₀ organic evaporation source was raised to 400°C or more, the evaporation rate was controlled to 0.6 Å/s to 1.2 Å/s, and the evaporation thickness was set to 100 nm. After the evaporation of C₆₀, the temperature of the organic evaporation source of BCP (2,9-dimethyl-4,7-diphenyl-1,10-phenanthroline) was raised to 120°C or more, the evaporation rate was controlled to 0.4 Å/S, and the evaporation thickness was set to 10 nm.
Step (5). Preparation of metal electrode layer: The metal electrode layer was evaporated above the electron transport layer, the material selected as Ag. The air pressure in the chamber of the vacuum evaporation machine was pumped to 5×10⁴ Pa or less, the evaporation current was applied to 120 A, and the evaporation rate was 8 Å/s.

In addition, it is to be noted that the number of layers and the thickness of the encapsulation layer can be adaptively prepared according to the actual encapsulation requirements. For example, the encapsulation structure was designed to include three encapsulation layers, namely a first encapsulation layer 21, a second encapsulation layer 24, and a third encapsulation layer. A planarization layer 22 is disposed between the first encapsulation layer 21 and the second encapsulation layer 24 and between the second encapsulation layer 24 and the third encapsulation layer. The principle of the multi-layer encapsulation layer structure is similar, which is not elaborated here.

### Example 2

On the basis of Example 1, it differs from Example 1 in that:
The planarization layer 22 is a curable adhesive and a desiccant 23, and a weight ratio of the desiccant 23 in the planarization layer 22 is 1%.

The curable adhesive is polyacrylate (polyacrylate is a thin-film encapsulation ink purchased from Xi'an SMART MATERIALS Co., Ltd.). The desiccant is a mixture of barium oxide particles and strontium oxide particles, with the mass of the strontium oxide particles accounting for 88% of the total mass of the strontium oxide particles and the calcium oxide particles, the strontium oxide particle has an average particle size of 1 µm, and the calcium oxide particle has an average particle size of 1 µm. The has a thickness of 10 µm.

### Example 3

On the basis of Example 1, it differs from Example 1 in that:
The planarization layer 22 is a curable adhesive and a desiccant 23, and a weight ratio of the desiccant 23 in the planarization layer 22 is 0.01%.

The curable adhesive is polyacrylate, and the polyacrylate includes a silicone compound (polyacrylate is a thin-film encapsulation ink purchased from Xi'an SMART MATERIALS Co., Ltd.). The desiccant is a mixture of barium oxide particles and strontium oxide particles, with the mass of the strontium oxide particles accounting for 95% of the total mass of the strontium oxide particles and the calcium oxide particles, the strontium oxide particle has an average particle size of 0.1 µm, and the calcium oxide particle has an average particle size of 0.5 µm. The has a thickness of 0.3 µm.

### Example 4

On the basis of Example 1, it differs from Example 1 in that:
The planarization layer 22 is a curable adhesive and a desiccant 23, and a weight ratio of the desiccant 23 in the planarization layer 22 is 0.01%.

The curable adhesive is polyacrylate (polyacrylate is a thin-film encapsulation ink purchased from Xi'an SMART MATERIALS Co., Ltd.), wherein the desiccant 23 is barium oxide particles.

### Comparative Example 1

On the basis of Example 1, it differs from Example 1 in that the planarization layer 22 in Comparative Example 1 is only a curable adhesive.

To further verify the effectiveness of the perovskite photovoltaic module according to the present disclosure, performance tests were conducted on the perovskite photovoltaic modules obtained in Example 1 and Comparative Example 1, with the test process and results as follows:
The PCE-t curve (curve of the change of normalized efficiency over time) was determined using a solar simulator, with the light intensity of the solar simulator set to 100 mA/cm². The experimental conditions were illumination at atmospheric pressure, a temperature of 20°C, and a humidity of 30%.

FIG. 2 is a graph showing a change in power conversion efficiency over time of a perovskite photovoltaic modules prepared in Example 1 and Comparative Example 1 according to the present disclosure in an external air environment. From Fig. 2, it can be seen that the perovskite photovoltaic module prepared in Example 1 maintains an initial power conversion efficiency of 90% or more after 3600 h in an external air environment, while the power of the perovskite photovoltaic module in Comparative Example 1 drops to 70% of the initial value within the same time. Through comparison, it can be seen that the desiccant 23 is provided in the planarization layer 22, which plays a very important role in preventing moisture and oxygen and enhancing the stability of the cell module.

The description above is merely a specific embodiment of the present disclosure, which enables those skilled in the art to understand or implement the present disclosure. Various modifications to these examples are apparent to those skilled in the art, and the general principles defined herein are implemented in other examples without departing from the spirit or scope of the present disclosure.

It is to be understood that the present disclosure is not limited to what has been described above, and that various modifications and changes can be made without departing from the scope. The scope of the present disclosure is limited only by the appended claims..

## Claims

1. A perovskite photovoltaic module, comprising an encapsulation structure stacked on a perovskite solar cell (10), wherein the encapsulation structure comprises a plurality of encapsulation layers, and a planar layer (22) is disposed between adjacent encapsulation layers; and the planarization layer(22) comprises a curable adhesive and a desiccant (23), both of which have a water content of less than 100 ppm.

2. The perovskite photovoltaic module according to claim 1, wherein the desiccant (23) is doped in the curable adhesive, and a weight ratio of the desiccant (23) within the planarization layer (22) is 0.01% to 1%.

3. The perovskite photovoltaic module according to claim 1, wherein the desiccant (23) is a metal oxide-based desiccant with an average particle size of 0.01 µm to 10 µm.

4. The perovskite photovoltaic module according to claim 3, wherein the metal oxide-based desiccant is a powdered metal oxide, and the powdered metal oxide is at least one of BaO, CaO, SrO, MgO, and a molecular sieve.

5. The perovskite photovoltaic module according to claim 1, wherein the curable adhesive is made of at least one of epoxy resin and polyacrylate.

6. The perovskite photovoltaic module according to claim 1, wherein the planarization layer (22) has a thickness of 0.3 µm to 10 µm.

7. The perovskite photovoltaic module according to claim1, wherein the planarization layer is prepared by a printing or adhesive coating method.

8. The perovskite photovoltaic module according to claim 1, wherein the plurality of encapsulation layers are each made of dense inorganic materials; and the dense inorganic material is at least one of Siₓ₁O_{y1}, Siₓ₂N_{y2}, SiOₓ₃N_{y3}, ZnO, Sb₂O₂, Alₓ₄O_{y4}, In₂O₂, and SnO₂, wherein x1, x2, x3, x4, y1, y2, y3, and y4 are all integers in a range of 1 to 5.

9. A preparation method of the perovskite photovoltaic module according to any one of claims 1 to 8, wherein the preparation method comprising: preparing a first encapsulation layer above a perovskite solar cell, preparing a planarization layer above the first encapsulation layer, and finally preparing a second encapsulation layer above the planarization layer, repeating the preparation process until a preparation of the required number of encapsulation layers is completed.

10. Application of a perovskite photovoltaic assembly, comprising application of the perovskite photovoltaic assembly as claimed in any one of claims 1 to 8 in a solar cell.
